# EUROPÄISCHE PATENTSCHRIFT

(11) **EP 2 069 663 B1**
(45) Veröffentlichungstag und Bekanntmachung des Hinweises auf die Patenterteilung: **01.04.2020**
(21) Anmeldenummer: 07788085.4
(22) Anmeldetag: 31.07.2007
(51) Int. Cl.: F16K 24/00, F21V 31/03, F16H 57/027, F16K 24/04, H05K 5/02, H02K 5/10

(54) **DRUCKAUSGLEICHSELEMENT, INSBESONDERE ZUM DRUCKAUSGLEICH IN EINEM GEHÄUSE**
PRESSURE COMPENSATION ELEMENT, IN PARTICULAR FOR PRESSURE COMPENSATION IN A HOUSING
ÉLÉMENT DE COMPENSATION DE PRESSIONS, UTILISÉ EN PARTICULIER POUR LA COMPENSATION DE PRESSIONS DANS UN LOGEMENT

(30) Priorität: 27.09.2006 DE 102006045996; 29.12.2006 DE 102006062044
(43) Veröffentlichungstag der Anmeldung: 17.06.2009
(73) Patentinhaber: Robert Bosch GmbH, 70442 Stuttgart (DE)
(72) Erfinder: LAUK, Detlef, 77871 Renchen (DE); WEGNER, Norbert, 77815 Buehl (DE); MAIER, Gerald, 77833 Ottersweier-Unzhurst (DE); HUESGES, Mario, 77830 Buehlertal (DE); MUELLER, Andreas, 76863 Herxheim (DE); NEIGEL, Regina, 77815 Buehl (DE)
(86) Internationale Anmeldenummer: PCT/EP2007/057890
(87) Internationale Veröffentlichungsnummer: WO 2008/037528

(56) Entgegenhaltungen:
- EP-A2- 1 363 069
- US-A- 2 526 794
- US-A- 3 845 878
- US-A- 3 908 684

## Beschreibung

Die vorliegende Erfindung betrifft ein Druckausgleichselement zum Druckausgleich eines Innenraums eines Gehäuses, insbesondere eines Elektrik-, Motor- oder Getriebegehäuses, eines Behälters oder dergleichen nach der im Oberbegriff des Anspruchs 1 näher definierten Art. Insbesondere betrifft die Erfindung ein Druckausgleichselement, welches den Innenraum des Gehäuses vor Feuchtigkeit, vor eindringenden Flüssigkeiten, etc. schützt und darüber hinaus einen verbesserten Schutz vor elektrostatischen Entladungen (ESD- Schutz, Electro Static Discharge) bietet.

### Stand der Technik

Das Gebrauchsmuster DE 295 11 683 U1 offenbart ein Druckausgleichselement in Gestalt einer Verschlusskappe für Behälter, Gehäuse, Flaschen oder dergleichen. Das Druckausgleichselement ist in der Wandung des Gehäuses eingebracht und weist eine druckausgleichende Membran auf, wobei die Verschlusskappe zumindest in ähnlicher Form eine zylinderförmige Struktur aufweist, da diese einen runden Kanal in einen Zylinder umfasst. Durch den Zylinder erstreckt sich daher die Öffnung, durch die der Druckausgleich erfolgen kann. Eine Membran ist innerhalb des Zylinders eingebracht, wobei die Membran unterhalb der außenseitigen Oberfläche des Gehäuses untergebracht ist. Bei einem möglichen Wassereintritt von der Außenseite kann sich dieses auf der Oberseite der Membran sammeln, was bei einem langfristigen Einsatz des Druckausgleichselementes zu einem Versagen der Membran führen kann. Ferner ist die Fertigungstechnik auf Ein um- bzw. Einspritzen der Membran begrenzt (Cast- In- Technik) oder diese muss zumindest aufwendig in den Körper der Verschlusskappe eingebracht werden. Es sind zwar sowohl plane als auch gewölbte Ausführungen der Membran offenbart, die gewölbte Ausführung entspricht jedoch lediglich der Kontur der Verschlusskappe, so dass die gewölbte Membran nicht einer freien Wölbung innerhalb der zylinderförmigen Struktur entspricht. Fertigungstechnisch gestaltet sich die Verschlusskappe mit dem Druckausgleichselement als sehr aufwendig, wobei hinzukommt, dass die Verschlusskappe nicht vollständig durch einen Deckel vor mechanischen Einflüssen von der Außenseite des Gehäuses geschützt ist. Bei einer Beschädigung der Membran können Flüssigkeiten sowohl in das Gehäuse ein- als auch aus dem Gehäuse austreten.

Aus der US 2,526,794 A ist ein Behälter bekannt, auf dessen Kopfteil ein kombiniertes Ventil-, Anschluss- und Druckausgleichselement aufgesetzt ist. Dabei ist das Druckausgleichselement in das Ventilelement eingeschraubt, das seinerseits in die Behälterobenwand eingesetzt ist. Das Druckausgleichselement ist als gebautes Element aufgebaut und weist eine Abdeckkappe auf, die auf ein Grundelement aufgeschraubt wird und sämtliche Bauteile des Druckausgleichselements zusammenhält. In die Kappe sind eine oder mehrere Bohrungen eingelassen, die direkt zu der Membran ausgerichtet sind.

Aus der Patentschrift DE 196 26 792 C1 ist ein Druckausgleichselement in Gestalt eines Verschlusselementes offenbart, welches als Kunststoff-Spritzgussteil ausgeführt ist. Dieses dient zum abgedichteten, lösbaren Verschließen einer in einem Gehäuse, Behälter oder dergleichen ausgebildeten komplementären Öffnung. In das Verschlusselement ist ein Filtermedium als Interface zwischen den Räumen innerhalb und außerhalb des Gehäuses integriert, wobei das Filtermedium im Trägerteil aus wenigstens einer ersten thermoplastischen Materialkomponente ein- oder angespritzt ist, wobei das Trägerteil mit wenigstens einer zweiten, hinsichtlich ihrer Konsistenz gegenüber der ersten Komponente unterschiedlichen thermoplastischen Materialkomponente zur Bildung eines resultierenden Formkörpers des Verschlusselementes umspritzt ist.

Zwar bietet die Technik des aus einem Spritzgussmaterial umspritzenden Formkörpers eine effektive Aufnahme der Membran, jedoch erfordert die Technik des Kunststoff-Umspritzens wenigstens eine Vertiefung, innerhalb der die Membran eingebracht ist, wobei die Vertiefung die Öffnung bildet, durch die der Druckausgleich stattfinden kann. Auch dieser Ausführungsform haftet der Nachteil an, dass sich über der Membran eine Kavität in Form einer Vertiefung bildet, welche sich mit Flüssigkeit füllen und die Membran außer Funktion setzen kann. Ferner besteht nicht die Möglichkeit, die Membran in einer gewölbten Form in die Aufnahme einzubringen. Darüber hinaus existiert keine Möglichkeit, die Membran mittels eines Deckels, eines Verschlusses oder dergleichen vor mechanischen Einflüssen aus Richtung der Außenseite zu schützen.

Weiterhin sind Druckausgleichselemente bekannt, welche Membranen aufweisen, die auf eine Trägerstruktur aufgeschweißt oder geklemmt werden. Das Aufschweißen kann mittels eines Laserstrahlschweißverfahrens oder eines Ultraschallschweißverfahrens erfolgen. Dabei wird die Membran auf die Außenseite der Aufnahmestruktur aufgebracht, wobei diese von der Außenseite weder vor Feuchtigkeit, Flüssigkeiten und dergleichen geschützt ist, noch einen Schutz vor mechanischen Einwirkungen bietet. Eine Beschädigung der Membran durch eine Flüssigkeit oder eine mechanische Einwirkung führt daher oft zum Versagen des Druckausgleichselementes.

EP 1 363 069 A2 offenbart ein Gehäuse mit einem Druckausgleichselement, das eine zylinderförmige Struktur mit einem sich durch diese hindurch erstreckenden Ventilationskanal umfasst.

Es ist daher die Aufgabe der vorliegenden Erfindung, ein Druckausgleichselement zum Druckausgleich eines Gehäuses zu schaffen, welches die Nachteile des vorgenannten Standes der Technik vermeidet und einen effektiven Schutz vor Flüssigkeiten sowie vor mechanischen Einwirkungen bietet.

### Offenbarung der Erfindung

Diese Aufgabe wird durch ein Gehäuse gemäß Anspruch 1 gelöst. Vorteilhafte Weiterbildungen der Erfindung sind in den abhängigen Ansprüchen angegeben.

Die Erfindung schließt die technische Lehre ein, dass sich die zylinderförmige Struktur in Richtung zur Außenseite hin erstreckt, um eine Erhöhung aus der Wandung des Gehäuses zu bilden, und diese durch eine ringförmige Endfläche begrenzt ist, auf der die Membran in einer gewölbten, kalottenartigen Gestalt aufgebracht ist, und wobei das Druckausgleichselement ferner einen Schutzdeckel umfasst, welcher sich in Richtung der Außenseite beabstandet zur Membran über der zylinderförmigen Struktur erstreckt.

Die zylinderförmige Struktur bietet in ihrer Ausführung den Vorteil, dass Flüssigkeiten, die über die Außenseite der Wandung fließen können oder diese zumindest benetzen, nicht an die Membran gelangen. Der Grund liegt in der erhöhten Einbaulage der Membran, welche endseitig auf der zylinderförmigen Struktur angebracht ist, wobei sich die zylinderförmige Struktur wenigstens so weit aus der Wandung heraus in Richtung zur Außenseite erstreckt, dass Flüssigkeiten nicht unmittelbar an die Membran gelangen können. Durch das damit verbesserte Wasserablaufverhalten wird erreicht, dass das auf der Außenseite der Wandung fließende oder stehende Wasser um die zylinderförmige Struktur herumströmt, und nicht über die Membran gelangen kann. Lediglich große Wassermengen können an die Membran gelangen, welche jedoch im normalen Einsatz des Druckausgleichselementes nur selten auftreten. Geometrien oder Abstände der Teileoberflächen beispielsweise 4 mm überschreiten, verhindern ein Anhaften von hartem Wasser, was durch die Oberflächenspannung bzw. die Kontaktwinkel des Wassers beschrieben werden kann. So können auch Flüssigkeiten, welche nur einen geringen Kontaktwinkel aufweisen, und daher eine verstärkte Wechselwirkung mit der Wandung zeigen, davon abgehalten werden, an die Membran zu gelangen, um diese zu benetzen. Ein Benetzen der Membran mit einer von außen eindringenden Flüssigkeit kann die Poren der Membran zusetzen und diese undurchlässig machen. Damit wird die Membran außer Funktion gesetzt, und aufgrund des sich bildenden Über- oder Unterdrucks innerhalb des Gehäuses kann die Membran reißen. Durch die erfindungsgemäße Anordnung der Membran wird ein Benetzen der Membran mit einer Flüssigkeit zumindest in ihrer Gefahr verringert, so dass die Lebensdauer der Membran erhöht wird.

Der Schutzdeckel weist eine planscheibenartige Grundstruktur auf, an der planseitig stegförmige Anformungen angebracht sind, welche eine in radialer Richtung der planscheibenartigen Grundstruktur ausgebildete Krümmung aufweisen, und in Umfangsrichtung der Grundstruktur gleich verteilt an dieser angeformt sind. Im Ergebnis entsteht eine turbinenradähnliche Geometrie des Schutzdeckels mit der Vielzahl von Anformungen, wobei durch die turbinenradähnliche Geometrie verhindert wird, dass ein linearer Durchgangsweg radialseitig von der Außenseite des Schutzdeckels in die Innenseite des Schutzdeckels entsteht. Lediglich eine gekrümmte Verbindung ist durch die sichelartigen Anformungen möglich, was die Sicherheit gegen elektrostatische Endladungen von der Außenseite in den Innenraum erhöht. Solange nur gekrümmte Wege eine Verbindung zwischen dem Innen- und dem Außenraum ermöglichen, ist eine erhöhte Sicherheit gegen einen elektrostatischen Durchschlag gewährleistet. Die turbinenradähnlichen, sichelartigen Anformungen können derart dicht zueinander angeordnet sein, dass die Außenseite eines benachbarten Steges die Innenseite eines weiteren Steges zumindest auf einem größeren Teil überlappt. Somit entsteht zwar die Möglichkeit eines Gas- und Flüssigkeitsaustausches, jedoch ist es nicht möglich, eine direkte Verbindung zwischen der Innenseite und der Außenseite in Form einer Geraden zu bilden.

Der erfindungsgemäße Schutzdeckel erstreckt sich über der Membran, wobei zwischen der Membran und dem Schutzdeckel ein gewisser Abstand vorliegt (beispielsweise 4 mm), um eine Kapillarwirkung des Wassers zu verhindern, so dass zugleich eine Ansammlung von Wasser zwischen der Membran und dem Schutzdeckel vermieden wird. Insbesondere bewirkt die gewölbte, kalottenartige Gestalt der Membran, dass die Ansammlung von Wasser über der Membran bzw. zwischen der Membran und dem Schutzdeckel vermieden wird, und dort nicht eintrocknen kann, und Trocknungsrückstände nicht zurückbleiben.

Die Membran hat zunächst im Außenbereich eine plane Struktur, wobei sich die Wölbung lediglich über dem Durchmesser der zylinderförmigen Struktur erstreckt. Damit kann die Membran in der planen Außenseite an die ringförmige Endfläche der zylinderförmigen Struktur angebracht werden.

Eine vorteilhafte Weiterbildung der Erfindung sieht vor, dass die Membran mittels eines Ultraschallschweißverfahrens auf die Endfläche aufgebracht ist. Ferner kann auch der Schutzdeckel mittels eines Ultraschallschweißverfahrens auf den Körper des Druckausgleichselementes aufgebracht werden. Das Ultraschallschweißverfahren ist ein besonders geeignetes Verfahren, um zwei aus einem Kunststoff hergestellte Bauteile miteinander druckdicht zu verbinden. Die thermische und mechanische Belastung der Bauteile ist dabei minimal, wobei die Wärmeeinbringung lediglich auf die Fügestelle begrenzt werden kann, so dass die Membran in ihrer Struktur unbeeinflusst auf die Endseite der zylinderförmigen Struktur aufgeschweißt werden kann. Das Aufbringen des Schutzdeckels kann ebenfalls auf vorteilhafte Weise mit einem Laserstrahlschweißverfahren ausgeführt werden.

Vorteilhafterweise ist zur Abstützung der Membran innerhalb der zylinderförmigen Struktur eine Stützstruktur ausgebildet. Die Stützstruktur kann einteilig mit der zylinderförmigen Struktur ausgebildet sein, und kann die Gestalt eines Stützkreuzes aufweisen. Die durch das Stützkreuz gebildeten Zwischenräume bilden den Ventilationskanal, so dass bei einer Kreuzartigen Struktur vier einzelne Ventilationskanäle gebildet werden. Die Stützstruktur weist auf der Außenseite eine Wölbung auf, die der Wölbung der Membran entspricht. Wird die Membran durch einen Unter- oder Überdruck belastet, so kann sich zumindest in einer Richtung die Membran an das Stützkreuz anlegen, so dass die mechanische Belastung der Membran gering gehalten werden kann.

Eine weitere vorteilhafte Ausführungsform der Erfindung sieht vor, dass sich der Ventilationskanal innerhalb der zylinderförmigen Struktur labyrinthartig durch die Stützstruktur hindurch erstreckt, so dass eine lineare Ausbildung des Ventilationskanals verhindert ist. Wie bereits bei der turbinenradähnlichen Struktur des Schutzdeckels erwähnt, kann auch der Ventilationskanal innerhalb der zylinderförmigen Struktur Verwinkelungen und Krümmungen aufweisen, so dass ein linearer Ventilationskanal verhindert wird. Mögliche elektrostatische Entladungen können durch den gekrümmten Verlauf des Ventilationskanals nicht von der Außenseite durch das Druckausgleichselement in die Innenseite gelangen. In der Innenseite können beispielsweise empfindliche Elektroniken angeordnet werden, wie ein Motorsteuergerät, elektrostatisch empfindliche Elektronikkomponenten, etc.

Aus fertigungstechnischen Gründen ist es von besonderem Vorteil, dass der wenigstens aus der zylinderförmigen Struktur und der Stützstruktur gebildete Körper des Druckausgleichselementes mittels eines Kunststoff-Spritzgussverfahrens hergestellt ist und in die Wandung des Gehäuses eingesetzt und mit dieser dichtend verbunden ist oder einstückig und materialeinheitlich mit diesem ausgebildet ist. Ist die Wandung des Gehäuses selbst mittels eines Spritzgussverfahrens hergestellt, so kann die Möglichkeit genutzt werden, das Druckausgleichselement einheitlich als einziges Spritzgussbauteil mit der Wandung des Gehäuses herzustellen. Die labyrinthartige Struktur, das Stützkreuz und die zylinderförmige Struktur selbst können dabei so ausgebildet sein, dass keine zusätzlichen Schieber innerhalb des Spritzgusswerkzeugs erforderlich sind. Ein Spritzgusswerkzeug mit lediglich einer Teilungsebene kann dann ausreichend sein, wenn in der Erstreckungsrichtung der zylinderförmigen Struktur keine Hinterschneidungen vorgesehen werden. Sollte es aus konstruktiven Gründen vorteilhaft sein, das Druckausgleichselement als Einzelteil auszubilden, so kann dieses ebenfalls mit einem Ultraschallschweißverfahren in die Wandung des Gehäuses eingesetzt und mit dieser druckdicht verbunden werden. Ein Laserstrahlschweiß-, Klebe-, Schraub- oder Pressverfahren bietet eine mögliche Verbindungsvariante.

Die vorliegende Erfindung betriff ferner ein Verfahren zur Herstellung des erfindungsgemäßen Gehäuses, wobei die Membran mittels einer Sonotrode auf die Endfläche der zylinderförmigen Struktur nach dem Verfahren eines Ultraschallschweißens aufgeschweißt wird, und die Sonotrode eine gewölbte, kalottenartige Aufnahmestruktur umfasst, in der die Membran zur Erzeugung der Wölbung aufgenommen wird. Vorteilhafterweise ist die Aufnahmestruktur in der Sonotrode nach innen gewölbt und weist einen Unterdruckanschluss auf, in dem ein Unterdruck erzeugt wird, und die Membran wird durch den Unterdruck während des Ultraschallschweißens in die nach innen gewölbte, kalottenartige Aufnahmestruktur hineingezogen. Nach dem Prinzip eines Sauggreifers kann die Membran in die Aufnahmestruktur eingesogen werden, so dass sich diese an die nach innen gewölbte Struktur in der Sonotrode anlegt. Durch die Abbildung der nach innen gewölbten Aufnahmestruktur in der Membran wird die Membran in dem gewölbten Zustand auf die Endfläche der zylinderförmigen Struktur aufgeschweißt, so dass diese nach dem Schweißverfahren die gewölbte Struktur beibehält.

Weitere, die Erfindung verbessernde Maßnahmen werden nachstehend gemeinsam mit der Beschreibung eines bevorzugten Ausführungsbeispiels der Erfindung anhand der Figuren näher dargestellt.

### Ausführungsbeispiel

Es zeigt:
- Figur 1: eine quergeschnittene Seitenansicht des Druckausgleichselementes mit einem an diesem eingebrachten Schutzdeckel;
- Figur 2: das Druckausgleichselement im Bereich der zylinderförmigen Struktur mit einem in dieser angeordneten Stützstruktur;
- Figur 3A: eine Ansicht eines ersten Ausführungsbeispiels des Schutzdeckels in einer ersten Ansicht; dieses Ausführungsbeispiel ist jedoch nicht erfindungsgemäß;
- Figur 3B: die Ausführung des Schutzdeckels gemäß der Figur 3A in einer weiteren Ansicht;
- Figur 4A: eine zweite Ausführungsform des Schutzdeckels in einer ersten Ansicht; diese Ausführungsform ist erfindungsgemäß;
- Figur 4B: die zweite Ausführungsform des Schutzdeckels in einer weiteren Ansicht;
- Figur 5: eine vereinfachte Darstellung einer Sonotrode zum Ultraschallschweißen der Membran des Druckausgleichselementes mit einer erfindungsgemäßen Aufnahmestruktur; und
- Figur 6: eine vergrößerte Darstellung der Aufnahmestruktur in der Sonotrode, in die die Membran zum Ultraschallschweißen eingebracht wird.

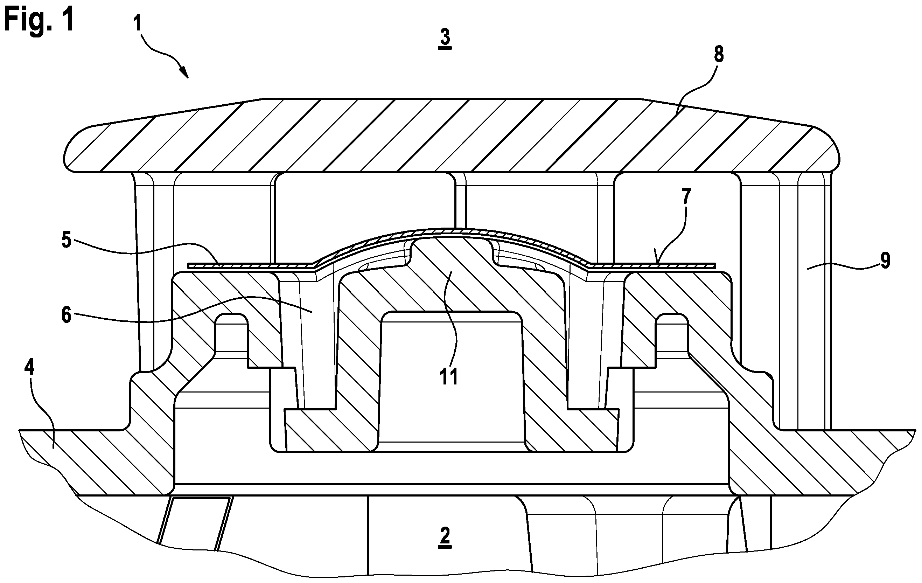

Das in der Figur 1 im Querschnitt dargestellte Druckausgleichselement ist mit dem Bezugszeichen 1 bezeichnet. Das Druckausgleichselement 1 ist innerhalb der Wandung 4 eines Gehäuses, insbesondere eines Elektrik-, Motor- oder Getriebegehäuses eines Behälters oder dergleichen eingebracht. Gemäß der Darstellung ist das Druckausgleichselement 1 einteilig und materialeinheitlich mit der Wandung 4 ausgebildet. Diese Darstellung ist rein beispielhaft, so dass das Druckausgleichselement 1 auch als Einzelteil in die Wandung 4 eingebracht werden kann.

Das Druckausgleichselement 1 dient zum Druckausgleich zwischen einem Innenraum 2 und einer Außenseite 3. Zwischen dem Innenraum 2 und der Außenseite 3 ist eine Membran 5 angeordnet, wobei die Membran 5 auf der Endfläche einer sich in Richtung der Außenseite 3 erstreckenden zylinderförmigen Struktur aufgebracht ist. Durch die zylinderförmige Struktur erhebt sich die Fügestelle bzw. die Aufnahmestelle der Membran 5 aus der Ebene der Wandung 4 heraus. Flüssigkeiten, die über die Wandung 4 auf der Außenseite 3 entlang laufen, bzw. auf dieser aufgebracht sind oder diese benetzen, können somit nicht an die Membran 5 gelangen. Ferner weist die Membran 5 eine in Richtung der Außenseite 3 gerichtete Wölbung auf, so dass die Membran 5 in Gestalt einer Kalotte bzw. einer Kugelkappe ausgebildet ist und dadurch Flüssigkeiten von dieser sofort ablaufen. Lediglich im Bereich der Fügestelle zwischen der Membran 5 und der Endfläche 7 der zylinderförmigen Struktur weist die Membran 5 eine ringförmige Planfläche auf, um eine gewisse Fügefläche für ein Fügeverfahren, insbesondere für ein Ultraschallschweißverfahren zu bieten.

Zwischen dem Innenraum 2 und der Außenseite 3 erstrecken sich Ventilationskanäle 6, welcher durch die zylinderförmige Struktur hindurch verlaufen. Die Ventilationskanäle 6 können mehrfach vorhanden sein, welche durch die Stützstruktur unterbrochen bzw. voneinander getrennt werden. Die Stützstruktur weist ebenfalls eine gekrümmte, kalottenartige Oberseite auf, gegen die sich die Membran 5 anlegen kann. Damit kann die Membran vor Überdehnungen geschützt werden, welche auftreten können, wenn die Druckdifferenz zwischen dem Innenraum 2 und der Außenseite 3 einen Grenzwert überschreitet.

Von der Außenseite 3 ist über das Druckausgleichselement 1 ein Schutzdeckel 8 aufgesetzt. Der Schutzdeckel 8 kann auf der Wandung 4 bzw. umfangsseitig am Druckausgleichselement 1 im Bereich der zylinderförmigen Struktur angeschweißt, angeklebt, geklemmt oder auf sonstige Weise angebunden werden und ist durch die zylinderartige Struktur zugleich zentriert. Der Schutzdeckel 8 umfasst eine Schutzfunktion, so dass die Membran 5 aus Richtung der Außenseite 3 vor mechanischen Einflüssen geschützt wird. Ferner weist der Schutzdeckel 8 stegartige Anformungen auf, welche durch fensterförmigen Unterbrechungen gebildet werden. Durch die fensterförmigen Unterbrechungen kann der Druckausgleich stattfinden, so dass der Schutzdeckel 8 eine gewisse Durchlüftung zwischen der Innenseite des Schutzdeckels, in der sich die Membran 5 befindet, und der Außenseite 3 stattfinden.

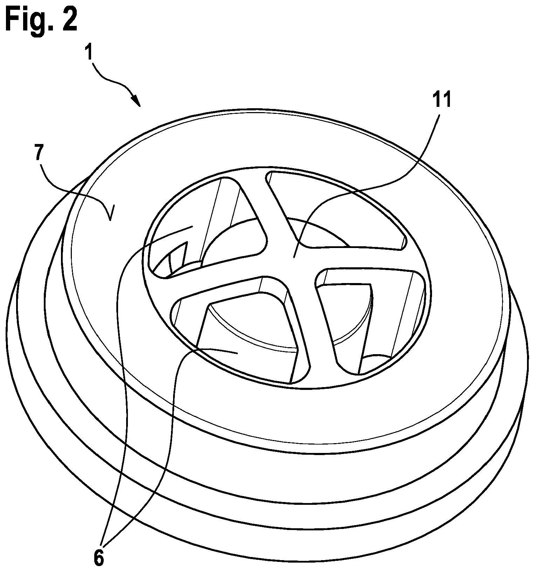

Figur 2 zeigt die geometrische Ausbildung der Stützstruktur 11 innerhalb der zylinderförmigen Struktur, welche durch die Endfläche 7 begrenzt ist. Die Membran ist in dieser Ansicht nicht gezeigt, um die genaue Ausbildung der Stützstruktur 11 darzustellen. Die Stützstruktur 11 ist in Gestalt eines Stützkreuzes ausgebildet, und kann einteilig mit der zylinderförmigen Struktur hergestellt werden. Die Zwischenräume zwischen den kreuzartigen Lamellen der Stützstruktur 11 bilden die Ventilationskanäle 6, welche eine gewisse Krümmung aufweisen, um eine lineare Verbindung von der Außenseite in die Innenseite zu vermeiden. Damit wird die Sicherheit gegen elektrostatische Entladungen erhöht, die somit nicht in den Innenraum gelangen können.

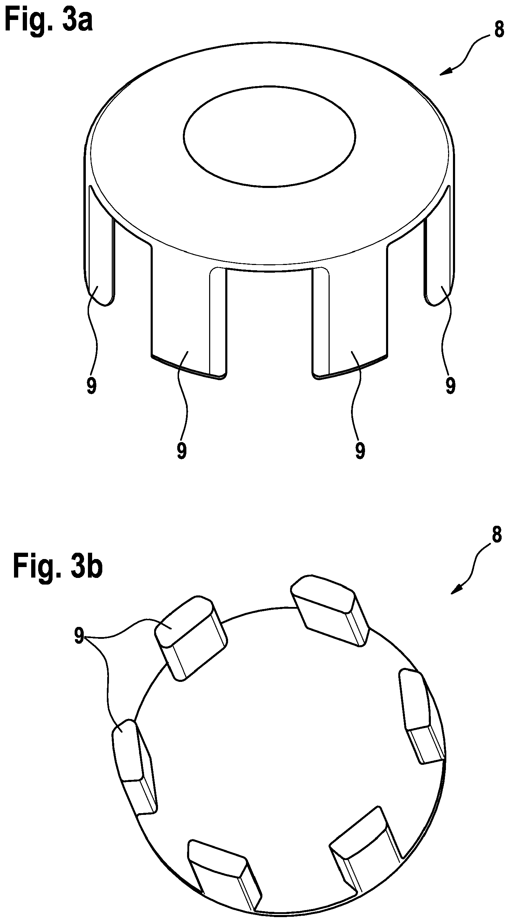

Die Figuren 3A und 3B zeigen eine perspektivische Ansicht eines ersten Ausführungsbeispiels des Schutzdeckels 8. Der Schutzdeckel 8 weist eine planscheibenartige Grundstruktur auf, an der mehrere stegartige Anformungen 9 ausgebildet sind. Der Schutzdeckel 8 kann als Kunststoff-Spritzgussbauteil hergestellt sein, so dass die stegartigen Anformungen einteilig mit der Grundstruktur des Schutzdeckels 8 hergestellt werden. Zwischen den stegartigen Anformungen sind Freiräume vorhanden, um den Druckausgleich des Druckausgleichselementes trotz des gefügten Schutzdeckels 8 zu gewährleisten.

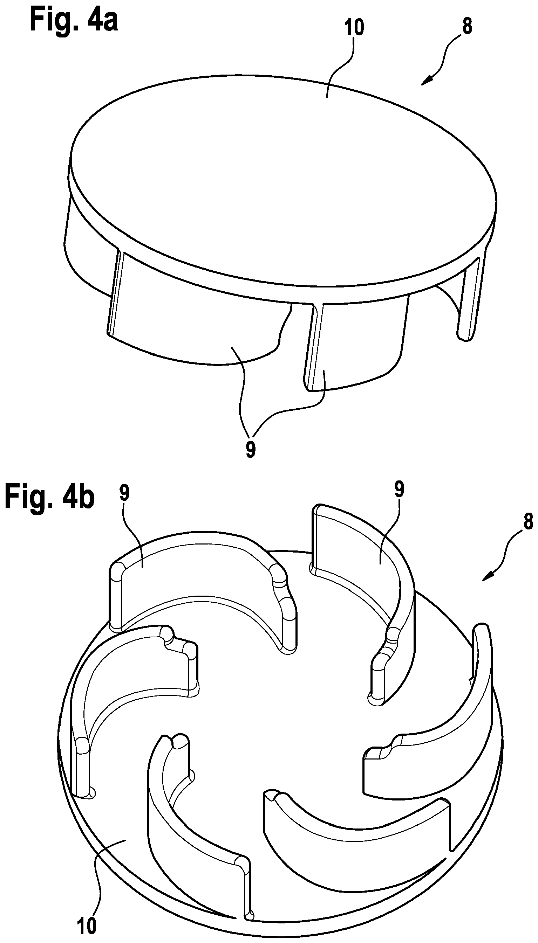

Die Figuren 4A und 4B zeigen ein weiteres Ausführungsbeispiel des Schutzdeckels 8, welcher neben der planscheibenartigen Grundstruktur 10 auf der innenliegenden Seite turbinenradähnliche Anformungen aufweist, welche als stegartige Anformungen 9 bezeichnet sind. Die als Turbinenradschaufeln gekrümmten stegartigen Anformungen verhindern eine lineare Verbindung zwischen der Außenseite und der Innenseite in Radialrichtung des Schutzdeckels 8. Die stegartigen Anformungen überlappen sich sodass eine direkte Verbindung von der Außenseite zur Innenseite nur über eine gekrümmte Verbindung möglich ist.

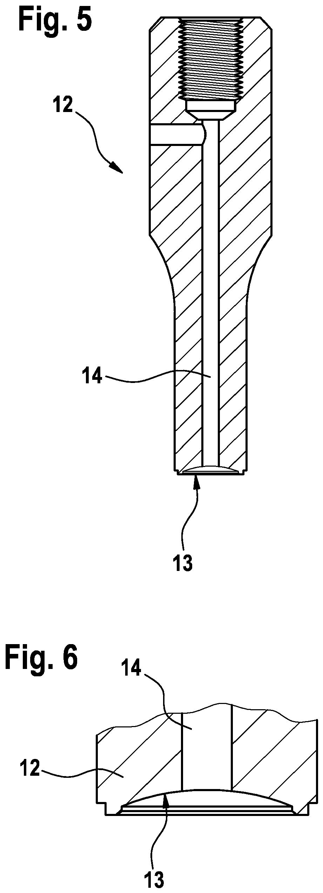

Figur 5 zeigt eine Sonotrode 12, welche beim Verfahren zur Herstellung des erfindungsgemäßen Druckausgleichselementes zur Anwendung gebracht wird. Die Sonotrode 12 dient als aktives Werkzeug zur Umsetzung eines Ultraschall-Schweißverfahrens, welche in eine Ultraschallschwingung versetzt wird, um in der Fügeebene zwischen der Membran - in der Darstellung gezeigt - und dem Fügepartner - ebenfalls nicht gezeigt - eine Wärme zu erzeugen, die die Materialien aufschmelzen, und somit gemeinsam verbinden. Insbesondere dient die Sonotrode zum Ultraschallschweißen der Membran auf die Endfläche der zylinderförmigen Struktur des Druckausgleichselementes.

Die Sonotrode 12 weist eine Aufnahmestruktur 13 auf, welche eine nach innen gewölbte, kalottenartige Struktur umfasst. Ferner weist die Sonotrode 12 einen Unterdruckanschluss 14 auf, welcher mittig in die Aufnahmestruktur 13 mündet. Wird ein Unterdruck auf den Unterdruckanschluss 14 angewendet, so wird die Membran in die Kontur der Aufnahmestruktur 13 hineingezogen, wodurch die kalottenartige Gestalt der Membran erzeugt wird. Das Verfahren zum Fügen der Membran auf die Endfläche sieht vor, dass der Unterdruck während des Ultraschall-Schweißprozesses aufrecht erhalten wird, um die Membran in der gekrümmten Gestalt auf die Endfläche aufzuschweißen. Somit verbleibt nach dem Schweißvorgang die Membran in der gekrümmten Gestalt, um die erfindungsgemäße Anordnung der Membran umzusetzen.

Figur 6 zeigt eine vergrößerte Ansicht der Aufnahmestruktur 13 der Sonotrode 12, in die der Unterdruckanschluss 14 mündet. Wird die Sonotrode 12 auf die zunächst planscheibenartige Membran aufgesetzt, so wird bei Anlegen eines Unterdrucks in dem Unterdruckanschluss 14 innerhalb der Aufnahmestruktur 13 ebenfalls ein Unterdruck erzeugt. Damit wird die Membran in die Aufnahmestruktur hineingezogen, und legt sich an der gewölbten Wandung an. Somit wird die Membran nicht nur in die gewünschte Krümmung gebracht, sondern kann ebenfalls im Sinne eines Sauggreifers mittels der Sonotrode gehändelt werden.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch macht.

## Patentansprüche

1. Gehäuse, insbesondere ein Elektrik-, Motor- oder Getriebegehäuse, an welchem ein Druckausgleichselement (1) vorgesehen ist, um einen Druck zwischen einem Innenraum (2) des Gehäuses gegenüber einer Außenseite (3) auszugleichen, wobei das Druckausgleichselement (1) in der Wandung (4) des Gehäuses einbringbar oder eingebracht ist und eine druckausgleichende Membran (5) umfasst, wobei das Druckausgleichselement (1) ferner eine zylinderförmige Struktur mit einem sich durch diese hindurch erstreckenden Ventilationskanal (6) umfasst,
wobei sich die zylinderförmige Struktur in Richtung zur Außenseite (3) hin erstreckt, um eine Erhöhung aus der Wandung (4) des Gehäuses zu bilden, und diese durch eine ringförmige Endfläche (7) begrenzt ist, auf der die Membran (5) in einer gewölbten, kalottenartigen Gestalt aufgebracht ist, und wobei das Druckausgleichselement (1) ferner einen Schutzdeckel (8) umfasst, welcher sich in Richtung der Außenseite (3) beabstandet zur Membran (5) über der zylinderförmigen Struktur erstreckt und wobei der Schutzdeckel (8) eine planscheibenartige Grundstruktur (10), an der planseitig, als Turbinenradschaufeln gekrümmte, stegförmige Anformungen (9) angeformt sind, welche eine in radialer Richtung der planscheibenartigen Grundstruktur (10) ausgebildete Krümmung aufweisen, und in Umfangsrichtung der Grundstruktur (10) gleich verteilt an dieser angeordnet sind, so dass eine lineare Verbindung zwischen der Außenseite (3) und der Innenseite in Radialrichtung des Schutzdeckels verhindert wird.

2. Gehäuse nach Anspruch 1 ,
**dadurch gekennzeichnet, dass** die Membran (5) mittels eines Ultraschallschweißverfahrens auf die Endfläche (7) aufgebracht ist.

3. Gehäuse nach einem der vorherigen Ansprüche,
**dadurch gekennzeichnet, dass** der Schutzdeckel (8) mittels eines Ultraschallschweißverfahrens auf dem Körper des Druckausgleichselements (1) aufgebracht ist.

4. Gehäuse nach einem der vorgenannten Ansprüche,
**dadurch gekennzeichnet, dass** innerhalb der zylinderförmigen Struktur eine Stützstruktur (11) zur Abstützung der Membran (5) eingebracht ist.

5. Gehäuse nach Anspruch 4,
**dadurch gekennzeichnet, dass** sich der Ventilationskanal (6) innerhalb der zylinderförmigen Struktur labyrinthartig durch die Stützstruktur (11) hindurch erstreckt, so dass eine lineare Ausbildung des Ventilationskanals (6) verhindert ist.

6. Gehäuse nach einem der Ansprüche 4 oder 5, **dadurch gekennzeichnet, dass** der wenigstens aus der zylinderförmigen Struktur und der Stützstruktur gebildete Körper des Druckausgleichselements (1) mittels eines Kunststoffspritzgussverfahrens hergestellt ist und in die Wandung (4) des Gehäuses eingesetzt und mit dieser dicht verbunden oder einstückig und materialeinheitlich mit diesem ausgebildet ist.

7. Verfahren zur Herstellung eines Gehäuses gemäß eines der Ansprüche 1 bis 6, **dadurch gekennzeichnet, dass** die Membran (5) mittels einer Sonotrode (12) auf die Endfläche (7) der zylinderförmigen Struktur nach dem Verfahren eines Ultraschallschweißverfahrens aufgeschweißt wird, und die Sonotrode eine gewölbte, kalottenartige Aufnahmestruktur (13) umfasst, in der die Membran (5) zur Erzeugung der gewölbten kalottenartigen Struktur aufgenommen wird.

8. Verfahren nach Anspruch 7,
**dadurch gekennzeichnet, dass** die Aufnahmestruktur (13) in der Sonotrode (12) nach innen gewölbt ist und einen Unterdruckanschluss (14) aufweist, in dem ein Unterdruck erzeugt wird und die Membran (5) durch den Unterdruck während des Ultraschallschweißens in die nach innen gewölbte, kalottenartige Aufnahmestruktur (13) hineingezogen wird.

## Claims

1. Housing, in particular an electrical housing, motor housing, or gearbox housing, on which a pressure compensation element (1) for equalizing a pressure between an interior space (2) of the housing and an external side (3) is provided, wherein the pressure compensation element (1) is capable of being or is incorporated in the wall (4) of the housing and comprises a pressure-equalizing membrane (5), wherein the pressure compensation element (1) furthermore comprises a cylindrical structure having a ventilation duct (6) extending therethrough, wherein the cylindrical structure extends in the direction towards the external side (3) so as to form an elevation projecting from the wall (4) of the housing, and said cylindrical structure is delimited by an annular end face (7) to which the membrane (5) is attached in a bulging, dome-shaped design, and wherein the pressure compensation element (1) furthermore comprises a protective cover (8) which, so as to be spaced apart from the membrane (5) above the cylindrical structure, extends in the direction of the external side (3), and wherein the protective cover (8) has a basic structure (10) in the manner of a planar disk on which curved web-shaped mouldings (9) are moulded to the planar side as turbine wheel blades, said mouldings having a curvature that is configured in the radial direction of the basic structure (10) in the manner of a planar disk and being uniformly distributed on the basic structure (10) in the circumferential direction of the latter such that a linear connection is prevented in the radial direction between the external side (3) and the internal side of the protective cover.

2. Housing according to Claim 1,
**characterized in that** the membrane (5) is attached to the end face (7) by means of an ultrasonic welding method.

3. Housing according to one of the preceding claims, **characterized in that** the protective cover (8) is attached to the body of the pressure compensation element (1) by means of an ultrasonic welding method.

4. Housing according to one of the preceding claims, **characterized in that** a support structure (11) for supporting the membrane (5) is incorporated within the cylindrical structure.

5. Housing according to Claim 4,
**characterized in that** the ventilation duct (6) within the cylindrical structure extends through the support structure (11) in the manner of a labyrinth such that a linear configuration of the ventilation duct (6) is prevented.

6. Housing according to one of Claims 4 or 5, **characterized in that** the body of the pressure compensation element (1) that is formed at least from the cylindrical structure and the support structure is produced by means of a plastics-material injection moulding method and is inserted into the wall (4) of the housing and is tightly connected to said wall (4), or is configured so as to be in one piece and materially integral with said wall (4).

7. Method for producing a housing according to one of Claims 1 to 6,
**characterized in that** the membrane (5) is welded to the end face (7) of the cylindrical structure by means of a sonotrode (12) according to the method of an ultrasonic welding method, and the sonotrode comprises a bulging, dome-shaped receptacle structure (13) in which the membrane (5) is received in order for the bulging dome-shaped structure to be generated.

8. Method according to Claim 7,
**characterized in that** the receptacle structure (13) in the sonotrode (12) bulges inwardly and has a negative-pressure connector (14) in which negative pressure is generated, and the membrane (5) on account of the negative pressure, is drawn into the inwardly bulging dome-shaped receptacle structure (13) during the ultrasonic welding.

## Revendications

1. Boîtier, en particulier boîtier électrique, carter de moteur ou carter de transmission, au niveau duquel un élément de compensation de pression (1) est prévu, afin de compenser une pression d'un espace intérieur (2) du boîtier par rapport à un côté extérieur (3), dans lequel l'élément de compensation de pression (1) peut être introduit ou est introduit dans la paroi (4) du boîtier et comporte une membrane (5) de compensation de pression, dans lequel l'élément de compensation de pression (1) comporte en outre une structure cylindrique dotée d'un canal de ventilation (6) s'étendant à travers celui-ci, dans lequel la structure cylindrique s'étend en direction du côté extérieur (3) afin de former un relief à partir de la paroi (4) du boîtier, et celui-ci est limité par une surface d'extrémité annulaire (7) sur laquelle la membrane (5) est appliquée dans une forme bombée de type calotte, et dans lequel l'élément de compensation de pression (1) comporte en outre un couvercle de protection (8), lequel s'étend en direction du côté extérieur (3) de manière espacée de la membrane (5) au-dessus de la structure cylindrique, et dans lequel le couvercle de protection (8) comprend une structure de base (10) de type disque plan, sur laquelle sont formées, du côté plan, des parties façonnées (9) en forme de nervures courbées en tant qu'aubes de roue de turbine, lesquelles parties façonnées présentent une courbure formée dans la direction radiale de la structure de base (10) de type disque plan, et sont disposées sur la structure de base (10) de manière répartie uniformément dans sa direction périphérique, de telle sorte qu'une liaison linéaire entre le côté extérieur (3) et le côté intérieur soit empêchée dans la direction radiale du couvercle de protection.

2. Boîtier selon la revendication 1,
**caractérisé en ce que** la membrane (5) est appliquée sur la surface d'extrémité (7) à l'aide d'un procédé de soudage par ultrasons.

3. Boîtier selon l'une des revendications précédentes, **caractérisé en ce que** le couvercle de protection (8) est appliqué sur le corps de l'élément de compensation de pression (1) à l'aide d'un procédé de soudage par ultrasons.

4. Boîtier selon l'une des revendications précédentes, **caractérisé en ce qu'**une structure de support (11) servant au support de la membrane (5) est introduite à l'intérieur de la structure cylindrique.

5. Boîtier selon la revendication 4,
**caractérisé en ce que** le canal de ventilation (6) s'étend à l'intérieur de la structure cylindrique en forme de labyrinthe à travers la structure de support (11), de sorte qu'une réalisation linéaire du canal de ventilation (6) soit empêchée.

6. Boîtier selon la revendication 4 ou 5,
**caractérisé en ce que** le corps de l'élément de compensation de pression (1) formé au moins à partir de la structure cylindrique et de la structure de support est fabriqué à l'aide d'un procédé de moulage par injection de plastique et est inséré dans la paroi (4) du boîtier et est relié de manière étanche à celui-ci ou est réalisé d'un seul tenant avec celui-ci ou en le même matériau que celui-ci.

7. Procédé de fabrication d'un boîtier selon l'une des revendications 1 à 6, **caractérisé en ce que** la membrane (5) est soudée au moyen d'une sonotrode (12) sur la surface d'extrémité (7) de la structure cylindrique selon le procédé de soudage par ultrasons, et la sonotrode comporte une structure de réception (13) bombée de type calotte, dans laquelle la membrane (5) est reçue pour produire la structure bombée de type calotte.

8. Procédé selon la revendication 7,
**caractérisé en ce que** la structure de réception (13) dans la sonotrode (12) est bombée vers l'intérieur et comprend un raccord de dépression (14) dans lequel une dépression est générée et la membrane (5) est attirée dans la structure de réception (13) bombée vers l'intérieur de type calotte par la dépression pendant le soudage par ultrasons.
